# EUROPEAN PATENT APPLICATION

(11) **EP 3 667 341 A1**
(43) Date of publication of application: **17.06.2020**
(21) Application number: 19215619.8
(22) Date of filing: 12.12.2019
(51) Int. Cl.: G01R 31/327, H02H 1/00, H03K 17/18, H03K 17/687, H02H 3/04

(54) **POWER SOURCE CONTROL DEVICE**

(30) Priority: 12.12.2018 JP 2018232466
(71) Applicant: AISIN SEIKI KABUSHIKI KAISHA, Kariya-shi Aichi-ken, 448-8650 (JP)
(72) Inventor: TAKAGI, Kazunori, KARIYA-SHI, AICHI-KEN, 448-8650 (JP); AKAGI, Yusuke, KARIYA-SHI, AICHI-KEN, 448-8650 (JP)
(74) Representative: Cabinet Beau de Loménie

(57) **Abstract**

A power source control device (1) includes: a first switch unit (10) including a first diode (11) which enters conduction and non-conduction states when positive and negative terminals (2A, 2B) of a power source device (2) are connected thereto, respectively, and a first switch (12) connected in parallel to the first diode; a second switch unit (20) between the first switch unit and a load (L) driven by electric power, and including a second switch (22) configured to cut off the electric power, and a second diode (21) connected in parallel to the second switch and having a cathode terminal connected to the first switch; a voltage application unit (30) applying a voltage higher than a voltage from the power source device to the cathode terminal when the first and second switches are in an open mode; and a determination unit (40) determining whether the first switch fails, based on the voltages.

## Description

### TECHNICAL FIELD

This disclosure relates to a power source control device that is provided between a power source device and a load to which electric power output from the power source device is supplied.

### BACKGROUND DISCUSSION

In the related art, a power source control device, which is capable of switching between the supply and the cutoff of electric power output from a power source device, is used between the power source device and a load. The above-described power source control device may have the function of protecting the load in the case where a positive terminal and a negative terminal of the power source device are reversely connected (for example, JP 2018-2080A and JP 2012-65405A).

JP 2018-2080A discloses an on-board system. In this on-board system, a power source relay and a reverse connection relay which are connected in series to each other are provided between a battery and an inverter. The power source relay is provided in a battery side and the reverse connection relay is provided on a load side, and N-channel field effect transistors are used as the power source relay and the reverse connection relay.

JP 2012-65405A discloses a motor control device. This motor control device includes reverse connection protection means including a switching element which makes connection or cuts off connection between a battery and a motor, and a backflow prevention element which enters a conduction state when the battery is in forward connection and enters a non-conduction state to prevent the backflow of current when the battery is in reverse connection; and fault diagnosis means for diagnosing the reverse connection protection means for a fault based on a difference between a cutoff potential difference which is a potential difference between upstream and downstream of the reverse connection protection means when the switching element of the reverse connection protection means cuts off connection between the battery and the motor and a connection potential difference which is a potential difference between upstream and downstream of the reverse connection protection means when connection is made between the battery and the motor.

In the technique disclosed in JP 2018-2080A, a capacitor is provided closer to the load side than the reverse connection relay and is charged when the output voltage of the battery does not decrease, and when the output voltage of the battery decreases, the electric charge of the capacitor is prevented from flowing backward to the battery. However, it is not considered to diagnose whether or not the reverse connection relay fails in a shorted mode.

In addition, in the technique disclosed in JP 2012-65405A, the reverse connection protection means can be diagnosed for a fault; however, this fault diagnosis has to be controlled such that in effect, the switching element of the reverse connection protection means is in a closed mode. For this reason, there is a possibility that an electric power loss occurs due to the fault diagnosis, or in the case where a downstream device (for example, the motor) fails, current relating to the fault diagnosis flows to the device, and thus, the device is damaged.

Thus, a need exists for a power source control device that is capable of performing fault diagnosis with low electric power consumption while preventing a downstream device from being damaged.

### SUMMARY

A feature of a power source control device according to an aspect of this disclosure resides in that the power source control device includes a first switch unit that includes a first diode which enters a conduction state when a positive terminal of a power source device is connected to the first diode and enters a non-conduction state when a negative terminal of the power source device is connected to the first diode, and a first switch that is connected in parallel to the first diode; a second switch unit that is provided between the first switch unit and a load which is driven by electric power supplied from the power source device, and includes a second switch which is configured to cut off the electric power from the power source device, and a second diode which is connected in parallel to the second switch and has a cathode terminal which is connected to the first switch; a voltage application unit that applies a voltage with a voltage value, which is higher than a voltage value of a voltage output from the power source device, to the cathode terminal of the second diode when both of the first switch and the second switch are in an open mode; and a determination unit that determines whether or not the first switch fails, based on the voltage value of the voltage output from the power source device and the voltage value of the voltage applied by the voltage application unit.

When both of the first switch and the second switch are in an open mode, in the case where the voltage with the voltage value, which is higher than the voltage value of the voltage output from the power source device, is applied to the cathode terminal of the second diode, the potential of the cathode terminal of the second diode can be made different between the case where both of the first switch and the second switch do not fail and the case where the first switch fails. In addition, since the electric power of the power source device is not used in performing fault diagnosis, it is possible to perform the fault diagnosis with low electric power consumption. Therefore, according to this characteristic configuration, it is possible to properly determine whether or not the first switch fails with low electric power consumption while preventing a downstream device from being damaged.

It is preferable that the first switch and the second switch are N-channel field effect transistors.

A parasitic diode is formed from a source terminal toward a drain terminal in the N-channel field effect transistor. Therefore, according to the above-described configuration, since the parasitic diode can be used as the first diode or the second diode, it is possible to realize the power source control device with a low cost.

It is preferable that the load is a motor, and the voltage application unit applies a drive voltage for driving an N-channel field effect transistor provided in an inverter, which controls a current flowing through the motor, to the cathode terminal of the second diode.

According to the above-described configuration, since it is not necessary to provide a voltage generation device (for example, a converter or the like) for fault diagnosis that generates the voltage with the voltage value which is higher than the voltage value of the voltage output from the power source device, it is possible to realize the power source control device with a low cost.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a diagram showing the configuration of a power source control device; and
Fig. 2 is a schematic table regarding the determination by a determination unit.

### DETAILED DESCRIPTION

A power source control device disclosed here is configured to be able to protect a downstream device even in the case where a pair of positive and negative terminals of a power source device are reversely connected, and to be able to diagnose the protection function for a fault without affecting the downstream device. Hereinafter, a power source control device 1 of this embodiment will be described.

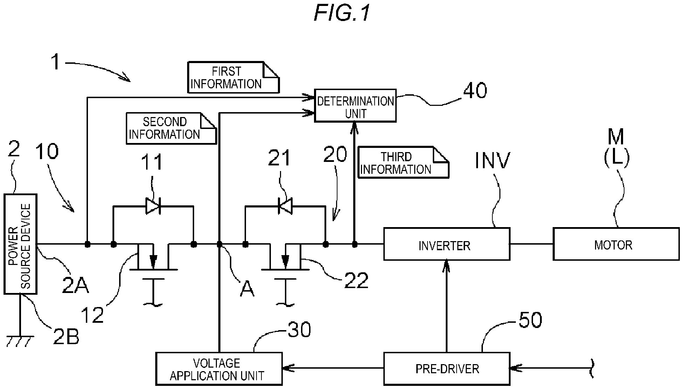

Fig. 1 is a diagram schematically showing the configuration of the power source control device 1. The power source control device 1 includes a first switch unit 10, a second switch unit 20, a voltage application unit 30, and a determination unit 40. Particularly, in order to perform a process relating to the above-described fault diagnosis, the voltage application unit 30 and the determination unit 40 have a CPU as a core member, and are built with software, hardware, or both thereof.

The first switch unit 10 includes a first diode 11 and a first switch 12. When the first diode 11 is connected to a positive terminal 2A of a power source device 2, the first diode 11 enters a conduction state, and when the first diode 11 is connected to a negative terminal 2B of the power source device 2, the first diode 11 enters a non-conduction state. The power source device 2 outputs electric power which is to be supplied to a load L through the power source control device 1. Specifically, a battery is equivalent to the power source device 2. The power source device 2 described above is provided with the positive terminal 2A and the negative terminal 2B. The negative terminal 2B is grounded, and the positive terminal 2A is connected to an anode terminal of the first diode 11. A cathode terminal of the first diode 11 is connected to an upstream terminal of a second switch 22 which will be described later. For this reason, when the second switch 22 is in a closed mode, the first diode 11 enters a conduction state where a forward current flows. On the other hand, in the case where the negative terminal 2B of the power source device 2 is connected to the anode terminal of the first diode 11, regardless of whether or not the second switch 22 is in a closed mode, the first diode 11 enters a non-conduction state where forward current does not flow.

The first switch 12 is connected in parallel to the first diode 11. An upstream terminal of the first switch 12 is connected to the anode terminal of the first diode 11, and a downstream terminal of the first switch 12 is connected to the cathode terminal of the first diode 11. In this embodiment, an N-channel field effect transistor (hereinafter, referred to as an "N-MOSFET") is used as the first switch 12, a source terminal of the first switch 12 is connected to the anode terminal of the first diode 11, and a drain terminal of the first switch 12 is connected to the cathode terminal of the first diode 11. In the case where it is confirmed that the positive terminal 2A of the power source device 2 is properly connected to the source terminal, the potential of a gate terminal with respect to the source terminal is set at a threshold voltage or greater, and thus, the first switch 12 enters a closed mode. In this case, the electric power output from the power source device 2 is supplied downstream through the first switch 12.

The second switch unit 20 includes a second diode 21 and the second switch 22. The second switch 22 is provided between the first switch unit 10 and the load L which is driven by the electric power supplied from the power source device 2, and the second switch 22 is capable of cutting off the electric power from the power source device 2. The upstream terminal of the second switch 22 is connected to the drain terminal of the first switch 12, and a downstream terminal of the second switch 22 is connected to a motor M through an inverter INV that controls a current flowing through the motor M which is an example of the load L. In this embodiment, similar to the first switch 12, an N-channel field effect transistor (hereinafter, referred to as an "N-MOSFET") is also used as the second switch 22, a drain terminal of the second switch 22 is connected to the drain terminal of the first switch 12, and the inverter INV is connected to a source terminal of the second switch 22. In the case where the electric power from the power source device 2 is to be supplied to the motor M, the potential of a gate terminal with respect to the source terminal is set at the threshold voltage or greater, and thus, the second switch 22 enters a closed mode. Therefore, the electric power output from the power source device 2 is supplied to the motor M through the second switch 22 and the inverter INV. On the other hand, in the case where the potential of the gate terminal with respect to the source terminal of the second switch 22 is set at less than the threshold voltage, the second switch 22 enters an open mode, and thus, the electric power output from the power source device 2 is cut off.

The second diode 21 is connected in parallel to the second switch 22, and a cathode terminal of the second diode 21 is connected to the first switch 12. In this embodiment, an N-MOSFET is used as the second switch 22. The cathode terminal of the second diode 21 is connected to the drain terminal of the second switch 22, and an anode terminal of the second diode 21 is connected to the source terminal of the second switch 22.

In the case where a fault determination is performed on the first switch 12, when both of the first switch 12 and the second switch 22 are in an open mode, the voltage application unit 30 applies a voltage with a voltage value, which is higher than the voltage value of a voltage output from the power source device 2, to the cathode terminal of the second diode 21. Here, in order to facilitate understanding, when a wiring connected to the cathode terminal of the second diode 21 is a node A, in the case where the first switch 12 and the second switch 22 are in an open mode, the electric power output from the power source device 2 is not supplied to the node A through the first switch 12 but through the first diode 11.

The voltage application unit 30 applies the voltage with a voltage value, which is higher than the voltage value of the voltage output from the power source device 2, to the node A. Therefore, the voltage output from the power source device 2 is not applied to the node A through the first diode 11, and also current output from the power source device 2 does not flow through the node A. In addition, in the case where a fault determination is performed on the first switch 12, since the first switch 12 and the second switch 22 are in an open mode, no voltage is applied thereto and no current flows therethrough also from the inverter INV through the second diode 21.

In this embodiment, the voltage application unit 30 applies a drive voltage for driving an N-MOSFET provided in the inverter INV to the cathode terminal of the second diode 21, namely, to the node A. Since the inverter INV is well known, the detailed description thereof will be omitted; however, the inverter INV performs frequency conversion to change DC electric power, which is output from the power source device 2, into AC electric power suitable for driving the motor M. The inverter INV includes a plurality of switching elements to perform the above-described frequency conversion. This switching element is configured using at least one of the above-described N-MOSFET and a P-channel field effect transistor (P-MOSFET).

In this embodiment, the inverter INV is configured using the above-described N-MOSFET. Therefore, a pre-driver 50 applies a drive voltage to a gate terminal of each N-MOSFET to drive the N-MOSFET. The drive voltage with a voltage value which is higher than the voltage value of the voltage output from the power source device 2 is used. The voltage application unit 30 acquires the above-described voltage with a voltage value which is higher than the voltage value of the voltage output from the power source device 2, and applies the voltage to the node A.

The determination unit 40 determines whether or not the first switch 12 fails, based on the voltage value of the voltage output from the power source device 2 and the voltage value of the voltage applied by the voltage application unit 30. The determination unit 40 acquires information (hereinafter, referred to as "first information") indicative of the voltage value of the voltage output from the power source device 2, and information (hereinafter, referred to as "second information") indicative of the voltage value of the potential of the node A. The determination unit 40 determines whether or not the first switch 12 fails, based on the voltage values and the potential difference. In addition, the determination unit 40 may be configured to also acquire information (hereinafter, referred to as "third information") indicative of the potential of the anode terminal of the second diode 21 at the time. Therefore, it is also possible to determine whether or not the second switch 22 fails.

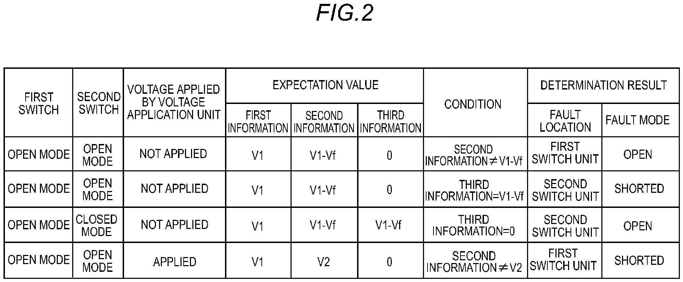

Fig. 2 is a schematic table regarding the determination by the determination unit 40. In the case where both of the first switch 12 and the second switch 22 are in an open mode and in the case where no voltage is applied by the voltage application unit 30, when the first switch unit 10 and the second switch unit 20 do not fail (in Fig. 2, indicated as an "expectation value"), the voltage value indicated by the first information is V1 (the voltage value of the output voltage of the power source device 2), the voltage value indicated by the second information is V1 - Vf (Vf is the forward voltage of the first diode 11), and the voltage value indicated by the third information is zero.

However, in the case where both of the first switch 12 and the second switch 22 are in an open mode and in the case where no voltage is applied by the voltage application unit 30, since the fact that the voltage value indicated by the second information is not V1 - Vf is due to the fact that the voltage output from the power source device 2 is not transmitted through the first diode 11, the determination unit 40 determines that the first switch unit 10 fails in an open mode.

On the other hand, in the case where both of the first switch 12 and the second switch 22 are in an open mode and in the case where no voltage is applied by the voltage application unit 30, since the fact that the voltage value indicated by the third information is V1 - Vf is due to the fact that the voltage output from the power source device 2 is transmitted through the second diode 21 or the second switch 22, the determination unit 40 determines that the second switch unit 20 fails in a shorted mode.

Subsequently, in the case where the first switch 12 is in an open mode and the second switch 22 is in a closed mode and in the case where no voltage is applied by the voltage application unit 30, when the first switch unit 10 and the second switch unit 20 do not fail, the voltage value indicated by the first information is V1, the voltage value indicated by the second information is V1 - Vf, and the voltage value indicated by the third information is V1 - Vf.

However, in the case where the first switch 12 is in an open mode and the second switch 22 is in a closed mode and in the case where no voltage is applied by the voltage application unit 30, since the fact that the voltage value indicated by the third information is zero is due to the fact that the voltage at the node A is not transmitted through the second switch 22, the determination unit 40 determines that the second switch unit 20 fails in an open mode.

Furthermore, in the case where both of the first switch 12 and the second switch 22 are in an open mode and in the case where a voltage is applied by the voltage application unit 30, when the first switch unit 10 and the second switch unit 20 do not fail, the voltage value indicated by the first information is V1, the voltage value indicated by the second information is V2 (V2 is the voltage value of the voltage applied by the voltage application unit 30, and V1 is less than V2), and the voltage value indicated by the third information is zero.

However, in the case where both of the first switch 12 and the second switch 22 are in an open mode and in the case where a voltage is applied by the voltage application unit 30, when the first switch unit 10 fails in a shorted mode, the voltage value indicated by the second information decreases less than V2. The reason is that since the supply capability for the voltage application by the voltage application unit 30 is sufficiently smaller than that of the power source device 2, a current flows to the power source device 2 through the first switch unit 10. For this reason, in the case where the voltage value indicated by the second information decreases less than V2, the determination unit 40 determines that the first switch unit 10 fails in a shorted mode. Incidentally, also when the second switch unit 20 fails in a shorted mode, the voltage value indicated by the second information decreases less than V2; however, based on another condition described above, it is possible to determine whether or not the second switch unit 20 fails in a shorted mode. Therefore, it is possible to distinguish between fault locations and between fault modes by performing determinations in order from above to below in Fig. 2. According to this embodiment, it is possible to determine whether or not the first switch unit 10 (reverse connection protection switch) fails in a shorted mode.

The power source control device 1 is configured as described above, and is capable of properly performing fault diagnosis.

### Other Embodiments

In the above-described embodiment, it is described that the first switch 12 and the second switch 22 are N-MOSFET's; however, at least one of the first switch 12 and the second switch 22 may be an N-MOSFET, or the first switch 12 and the second switch 22 can be also configured using switches other than an N-MOSFET.

In the above-described embodiment, it is described that the load L is the motor M; however, the load L may be loads other than the motor M.

In the above-described embodiment, it is described that the voltage application unit 30 applies the drive voltage for driving the N-MOSFET provided in the inverter INV, which controls a current flowing through the motor M, to the cathode terminal of the second diode 21; however, the voltage application unit 30 can be also configured to apply a voltage which is different from the drive voltage for driving the N-MOSFET provided in the inverter INV as long as the voltage has a voltage value higher than the voltage value of the voltage output from the power source device 2.

This disclosure can be used in a power source control device that is provided between a power source device and a load to which electric power output from the power source device is supplied.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

## Claims

1. A power source control device (1) comprising:
a first switch unit (10) that includes a first diode (11) which enters a conduction state when a positive terminal (2A) of a power source device (2) is connected to the first diode and enters a non-conduction state when a negative terminal (2B) of the power source device is connected to the first diode, and a first switch (12) that is connected in parallel to the first diode;
a second switch unit (20) that is provided between the first switch unit and a load (L) which is driven by electric power supplied from the power source device, and includes a second switch (22) which is configured to cut off the electric power from the power source device, and a second diode (21) which is connected in parallel to the second switch and has a cathode terminal which is connected to the first switch;
a voltage application unit (30) that applies a voltage with a voltage value, which is higher than a voltage value of a voltage output from the power source device, to the cathode terminal of the second diode when both of the first switch and the second switch are in an open mode; and
a determination unit (40) that determines whether or not the first switch fails, based on the voltage value of the voltage output from the power source device and the voltage value of the voltage applied by the voltage application unit.

2. The power source control device according to claim 1, wherein
the first switch and the second switch are N-channel field effect transistors.

3. The power source control device according to claim 1 or 2, wherein
the load is a motor (M), and
the voltage application unit applies a drive voltage for driving an N-channel field effect transistor provided in an inverter (INV), which controls a current flowing through the motor, to the cathode terminal of the second diode.
